# FASCICULE DE BREVET EUROPEEN

(11) **EP 3 250 064 B1**
(45) Date de publication et mention de la délivrance du brevet: **31.07.2019**
(21) Numéro de dépôt: 16714465.8
(22) Date de dépôt: 28.01.2016
(51) Int. Cl.: A41D 1/04, A41D 13/018

(54) **SYSTEME ELECTRONIQUE AMOVIBLE DE DECLENCHEMENT DU DEPLOIEMENT D'UN GILET GONFLABLE DE SECURITE**
ENTFERNBARES ELEKTRONISCHES SYSTEM ZUR AKTIVIERUNG DER AUSLÖSUNG EINER AUFBLASBAREN SICHERHEITSWESTE
REMOVABLE ELECTRONIC SYSTEM FOR ACTIVATING THE DEPLOYMENT OF AN INFLATABLE SAFETY VEST

(30) Priorité: 28.01.2015 FR 1550656
(43) Date de publication de la demande: 06.12.2017
(73) Titulaire: In&Motion, 74650 Chavanod (FR)
(72) Inventeur: HONORE, Valentin, 74000 Annecy (FR); TISSOT, Pierre-François, 78300 Chignin (FR); THOMAS, Rémi, 74940 Annecy Le Vieux (FR)
(74) Mandataire: Oudin, Stéphane
(86) Numéro de dépôt international: PCT/FR2016/050184
(87) Numéro de publication internationale: WO 2016/120568

(56) Documents cités:
- EP-A1- 2 033 532
- EP-A1- 2 745 720
- DE-A1- 3 010 842
- FR-A1- 2 936 470
- US-A1- 2002 118 109

## Description

### Domaine technique

La présente invention concerne le domaine de la prévention des blessures liées aux chutes à skis en général et plus particulièrement un système électronique de déclenchement du déploiement d'un gilet gonflable de sécurité.

### Technique antérieure

Avec la démocratisation de la pratique du ski et notamment du ski dit "extrême" tel que le ski hors-piste ou encore le ski lors de compétitions de ski alpin ou de ski-cross inspirées du moto-cross, on a cherché à mettre au point des systèmes destinés à protéger les skieurs lors de chute et plus spécifiquement les parties de leur corps les plus exposées telles que, par exemple, la nuque, le thorax, la colonne vertébrale, l'abdomen et les hanches.

Ainsi, on a développé des protections dites "passives" comprenant des renforts semi-rigides portées par le skieur sous sa combinaison. Ces protections sont certes efficaces mais présentent l'inconvénient majeur d'entraver les mouvements du skieur et donc de limiter ses performances.

Afin de remédier à cet inconvénient, des protections dites "actives" ont été élaborées. Ce type de protections est classiquement constitué d'un gilet gonflable de sécurité d'encombrement très faible et apte à être gonflé très rapidement par un gaz, lors de la chute du skieur, pour éviter à ce dernier de percuter violemment le sol. Le fonctionnement de ce gilet, qui comporte une enveloppe apte à être gonflée et un système de déclenchement solidaire de ladite enveloppe et apte à déclencher le gonflage de cette dernière et par conséquent le déploiement du gilet de sécurité, est analogue au fonctionnement des "airbags" installés dans les véhicules.

L'un des principaux problèmes rencontrés lors de la mise au point de ces protections actives est la mise au point des systèmes de déclenchement du déploiement dudit gilet gonflable de sécurité, car ces derniers, qui contiennent au moins des capteurs, microprocesseurs, mémoires, un module de communication sans fil, des moyens de gonflage aptes à gonfler ladite enveloppe, une interface utilisateur et un accumulateur d'énergie, avantageusement du type rechargeable, doivent en temps réel mesurer le mouvement de l'utilisateur via un algorithme et décider de déclencher le déploiement du gilet de sécurité dans les situations identifiées. Ces opérations ont des besoins en énergie élevés qui limitent significativement l'autonomie du système de déclenchement et donc du gilet gonflable de sécurité et nécessitent des rechargements fréquents qui immobilisent le gilet gonflage de sécurité le rendant inutilisable. Par ailleurs, les stratégies de déclenchement sont amenées à évoluer et à s'affiner avec le temps (évolution de l'algorithme, nouveaux capteurs,...) il est donc important d'être en mesure de pouvoir facilement faire évoluer le système de déclenchement, aussi bien au niveau logiciel que matériel et ce en tenant compte des conditions sévères d'utilisation à savoir un taux d'humidité élevé, des températures très basse et des chocs fréquents

Le document US2002118109 divulgue un système d'alerte de collision pour skieurs.

### Exposé de l'invention

Le but de la présente invention est donc de pallier les inconvénients précédemment cités et de proposer un système de déclenchement du déploiement d'un gilet gonflable de sécurité pour skieur fiable, résistant notamment aux conditions extrêmes d'utilisation, facile à réaliser, à mettre en oeuvre, à entretenir et faire évoluer tant sur le plan logiciel que matériel.

Conformément au premier objet de l'invention, il est donc proposé un système de déclenchement du déploiement d'un gilet gonflable de sécurité étant remarquable en ce qu'il comporte un carter agencé pour être solidaire dudit gilet gonflable de sécurité et muni d'un premier évidement apte à recevoir, de façon réversible, un boîtier comprenant au moins une carte électronique, des moyens de connexion et un accumulateur d'énergie, ledit premier évidement étant muni en partie supérieure d'un logement au fond duquel sont disposés les moyens de connexion du carter et dans lequel vient s'insérer au moins la partie supérieure du boitier pour permettre sa connexion de manière étanche avec ledit carter.

Lesdits moyens de connexion du carter sont associés de préférence à des éléments d'étanchéité réalisés à partir de forme en plastique et en mousse.

De manière avantageuse, le premier évidement comporte des rails de maintien disposés de part et d'autre du premier évidement et permettant le maintien du boitier au fond dudit premier évidement et son coulissement afin d'autoriser son insertion dans le logement, et un élément flexible de fixation situé en partie inférieure du premier évidement et assurant le verrouillage en position insérée dudit boitier.

Le boiter comporte des éléments d'accrochage conçus pour coopérer et s'insérer dans les rails de maintien du carter.

Selon un mode de réalisation préféré, le boiter a une forme présentant une asymétrie au niveau de sa partie supérieure afin de ne pouvoir le positionner et l'insérer que dans un seul sens.

La forme asymétrique de la partie supérieure du boitier est avantageusement reprise au moins en partie sur un motif réalisé sur le carter.

Les moyens de connexion du boitier sont situés sur sa partie supérieure et présentent une forme complémentaire à celle des éléments d'étanchéité du carter.

De manière préférée, le carter est solidaire d'une protection dorsale en matériau absorbant agencée pour être fixée sur ledit gilet gonflable de sécurité au droit des vertèbres lombaires d'un skieur lorsque ledit gilet est porté par ce dernier.

Par ailleurs, ledit carter comporte un deuxième évidement apte à recevoir, de façon réversible, des moyens de gonflage aptes à générer ou libérer du gaz pour permettre le déploiement du gilet de sécurité, lesdits moyens de gonflage étant de préférence une cartouche de gaz comprimé.

### Description sommaire des figures

D'autres avantages et caractéristiques ressortiront mieux de la description qui va suivre, d'un exemple particulier de réalisation, donné à titre d'exemple non limitatif, d'un système de déclenchement du déploiement d'un gilet gonflable de sécurité pour skieur conforme à l'invention, en référence aux dessins dans lesquels :

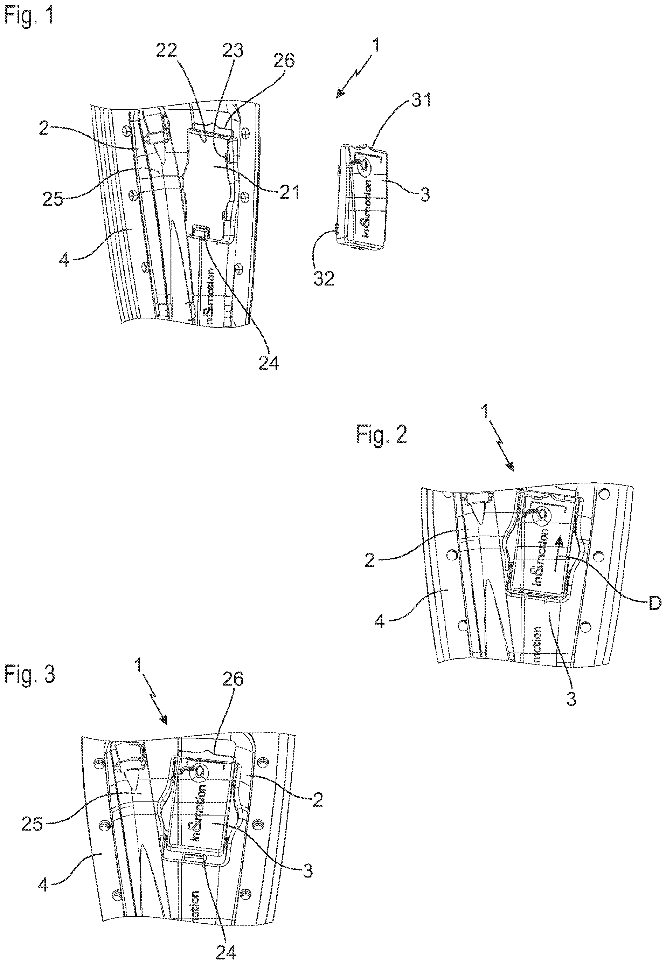

- les figures 1 à 3 sont des vues en perspective partielles montrant les différentes étapes de l'assemblage des deux éléments principaux constituant le système de déclenchement du déploiement d'un gilet gonflable de sécurité pour skieur selon l'invention.

### Meilleure manière de réaliser l'invention technique

Sur les figures 1 à 3, on a représenté un système de déclenchement 1 du déploiement d'un gilet gonflable de sécurité, non représenté sur les figures, destiné de préférence à un skieur, comportant un carter 2 solidaire dudit gilet gonflable et muni d'un premier évidement 21 apte à recevoir, de façon réversible, un boîtier 3 contenant l'électronique, ledit premier évidement 21 comportant en partie supérieure un logement 22 dans lequel vient s'insérer au moins la partie supérieure 31 du boitier 3 selon un mouvement allant de bas en haut afin d'éviter le ruissellement à l'intérieur (Cf. la direction D de la figure 2).

Dans la présente description, on va décrire système de déclenchement 1 du déploiement d'un gilet gonflable de sécurité porté par un skieur debout sur un sol horizontal. Il va de soi que le skieur peut être dans d'autre position les termes tes que, par exemple, horizontal, vertical, supérieur, inférieur, haut ou encore bas seront alors à adapter.

Par ailleurs, on désigne ici par "de façon réversible" le fait que le carter 2 et le boitier 3 sont conçus pour permettre une mise en place (ou au contraire un retrait) facile et rapide du boitier 3 dans le carter 2, ces opérations de mise en place ou de retrait pouvant être, d'une part, répétées de manière quasiment infinie sans altération du carter 2 ou du boitier 3 et, d'autre part, réalisées par un personne quelconque ne possédant pas de compétences techniques spécifiques ni d'outillages particuliers. Dans le cas d'un skieur, ces opérations de mise en place ou de retrait peuvent être même réalisées lorsque ledit skieur porte ses gants.

Le premier évidement 21 comporte des rails de maintien 23 disposés de part et d'autre du premier évidement 21 et permettant le maintien du boitier 3 au fond dudit premier évidement 21 et son coulissement afin d'autoriser son insertion dans le logement 22, et un élément flexible de fixation 24 situé en partie inférieure du premier évidement 21 et assurant le verrouillage en position insérée dudit boitier 3. Lesdits rails de maintien 23 et élément flexible de fixation 24 garantissent le parfait blocage en position insérée dans le logement 22 du boitier 3 même en conditions extrêmes d'utilisation, permettant ainsi au système de déclenchement 1 selon l'invention de remplir ses fonctions de détection et de déclenchement du déploiement du gilet gonflable de sécurité.

On comprend bien que le verrouillage du boitier 2 est en outre extrêmement facile et que les opérations de mise en place et de retrait du boitier 3 peuvent être réalisées très rapidement, en moins de 10 secondes, même si le skieur porte des gants.

Au fond du logement 22, le carter 2 comprend des moyens de connexion, non représentés sur les figures, permettant de réaliser une connexion entre ce dernier et le boitier 3, lesdits moyens de connexion comportant avantageusement des éléments d'étanchéité réalisés à partir de forme en plastique et en mousse.

Pour des raisons de simplicité de mise en oeuvre, les moyens de connexion du carter 2 permettent une connexion du type filaire avec le boitier 3.

Toutefois, on comprend bien que la connexion entre le carter 2 et le boitier 3 pourra être du type sans fil grâce à l'utilisation de technologie telle que, par exemple, la technologie Bluetooth® ou encore la technologie de radio identification RFID (de l'anglais radio frequency identification), sans sortir du cadre de la présente invention.

Selon un mode de réalisation préféré, le carter 2 est solidaire d'une protection dorsale 4 fixée sur ledit gilet gonflable de sécurité, située au droit des vertèbres lombaires d'un skieur lorsque ledit gilet est porté par ce dernier et réalisée dans une mousse absorbante. Ledit carter 2 comporte en outre un deuxième évidement 25 pour recevoir des moyens de gonflage aptes à générer ou libérer du gaz pour permettre le déploiement du gilet de sécurité, non représentés sur les figures, ces derniers étant avantageusement une cartouche de gaz comprimé.

Selon une variante de réalisation non représentée, les moyens de gonflage sont intégrés au boitier 3 et sont aptes, par exemple, à être insérés dans un évidement réalisé sur ledit boitier 3.

Le boitier 3 comporte une carte électronique, non représentée sur les figures, regroupant au moins les fonctions d'analyse du mouvement, de détection d'une situation à risque en relation avec plusieurs types de capteurs, de déclenchement des moyens de gonflage consistant, selon le mode de réalisation préféré, à la libération rapide du gaz contenu dans la cartouche de gaz comprimé.

Ladite carte électronique comporte en outre des moyens de connexion et des moyens de communication sans fil. Le boitier 3 comporte également un accumulateur d'énergie, non représenté sur les figures, avantageusement du type rechargeable apte à alimenter en énergie ladite carte électronique et à permettre le déclenchement des moyens de gonflage.

Le boiter 3, qui a une forme globalement parallélépipédique, présente toutefois une asymétrie au niveau de sa partie supérieure 31, reprise au moins en partie sur un motif 26 réalisé sur le carter 2, afin de ne pouvoir le positionner et l'insérer que dans un seul sens.

Par ailleurs, le boiter 3 comporte sur ses côtés longitudinaux des éléments d'accrochage 32 conçus pour coopérer et s'insérer dans les rails de maintien 23 du carter 2.

La partie supérieure 31 du boitier 2 comporte des équipements complémentaires tels qu'au moins un interrupteur, un port micro-USB pour la charge de la batterie et le transfert de données vers un ordinateur, et une prise d'alimentation des moyens de gonflage. Ces équipements complémentaires et lesdits moyens de connexion entre le boitier 3 et le carter 2 présentent une forme complémentaire à celle des éléments d'étanchéité du carter 2 afin de garantir une excellente étanchéité entre le carter 2 et le boitier 3 lorsque ce dernier est inséré dans le logement 2 et bloqué en position par les rails de maintien 23 et élément flexible de fixation 24.

Par ailleurs, on comprend bien que, lorsque le boitier 2 est insère de bas en haut et pénètre dans le logement 22 du carter 2, sa partie supérieure 31 est protégée car recouverte par la paroi du logement 22 (Cf. figure 2), l'ensemble de la zone de connexion entre ladite partie supérieure 31 et le carter 2 étant alors protégé. De plus, même si le boitier 2 est retiré, les moyens de connexion du carter 2 restent tout de même protégés.

Ainsi, on comprend bien que, puisqu'il est particulièrement facile de mettre en place ou de retirer le boitier 3 du carter 2, le skieur peut alors prendre plusieurs boitiers et les interchanger dès lors que l'accumulateur d'énergie de celui, qui est connecté dans le carter 2, est déchargé. Par ailleurs, il peut aussi recharger ou mettre à jour un boitier 3 tout en continuant d'utiliser son système de déclenchement 1 selon l'invention et le gilet gonflable de sécurité associé.

### Possibilité d'application industrielle

On comprend bien que le système de déclenchement 1 du déploiement d'un gilet gonflable de sécurité selon l'invention est de préférence utilisé par les skieurs. Toutefois, il est bien évident que le système de déclenchement 1 conforme à l'invention peut être adapté et utilisé pour des gilets gonflables de sécurité portés par un motard par exemple.

Enfin, il va de soi que les exemples de système de déclenchement 1 du déploiement d'un gilet gonflable de sécurité conformes à l'invention, caractérisé par les revendications, qui viennent d'être décrits ne sont que des illustrations particulières, en aucun cas limitatives de l'invention.

## Revendications

1. Système de déclenchement (1) du déploiement d'un gilet gonflable de sécurité étant **caractérisé en ce qu'**il comporte un carter (2) agencé pour être solidaire dudit gilet gonflable de sécurité et muni d'un premier évidement (21) apte à recevoir, de façon réversible, un boîtier (3) comprenant au moins une carte électronique, des moyens de connexion et un accumulateur d'énergie, ledit premier évidement (21) étant muni en partie supérieure d'un logement (22) au fond duquel sont disposés les moyens de connexion du carter (2) et dans lequel vient s'insérer au moins la partie supérieure (31) du boitier (3) pour permettre sa connexion de manière étanche avec ledit carter (2).

2. Système de déclenchement (1) selon la revendication 1 **caractérisé en ce que** lesdits moyens de connexion du carter (2) sont associés à des éléments d'étanchéité réalisés à partir de forme en plastique et en mousse.

3. Système de déclenchement (1) selon l'une quelconque des revendications 1 ou 2, **caractérisé en ce que** le premier évidement (21) comporte des rails de maintien (23) disposés de part et d'autre du premier évidement (21) et permettant le maintien du boitier (3) au fond dudit premier évidement (21) et son coulissement afin d'autoriser son insertion dans le logement (22), et un élément flexible de fixation (24) situé en partie inférieure du premier évidement (21) et assurant le verrouillage en position insérée dudit boitier (3).

4. Système de déclenchement (1) selon la revendication 3, **caractérisé en ce que** le boiter (3) comporte des éléments d'accrochage (32) conçus pour coopérer et s'insérer dans les rails de maintien (23) du carter (2).

5. Système de déclenchement (1) selon l'une quelconque des revendications 1 à 4 **caractérisé en ce que** le boiter (3) a une forme présentant une asymétrie au niveau de sa partie supérieure (31) afin de ne pouvoir le positionner et l'insérer que dans un seul sens.

6. Système de déclenchement (1) selon la revendication 5, **caractérisé en ce que** la forme asymétrique de la partie supérieure (31) du boitier (3) est reprise au moins en partie sur un motif (26) réalisé sur le carter (2).

7. Système de déclenchement (1) selon l'une quelconque des revendications 2 à 6, **caractérisé en ce que** les moyens de connexion du boitier (3) sont situés sur sa partie supérieure (31) et présentent une forme complémentaire à celle des éléments d'étanchéité du carter (2).

8. Système de déclenchement (1) selon l'une quelconque des revendications 1 à 7, **caractérisé en ce que** le carter (2) est solidaire d'une protection dorsale (4) en matériau absorbant agencée pour être fixée sur ledit gilet gonflable de sécurité au droit des vertèbres lombaires d'un skieur lorsque ledit gilet est porté par ce dernier.

9. Système de déclenchement (1) selon l'une quelconque des revendications 1 à 8, **caractérisé en ce que** ledit carter (2) comporte un deuxième évidement (25) apte à recevoir, de façon réversible, des moyens de gonflage aptes à générer ou libérer du gaz pour permettre le déploiement du gilet de sécurité.

10. Système de déclenchement (1) selon la revendication 9, **caractérisé en ce que** les moyens de gonflage sont une cartouche de gaz comprimé.

## Patentansprüche

1. Aktivierungssystem (1) zum Auslösen einer aufblasbaren Sicherheitsweste, **dadurch gekennzeichnet, dass** es ein Gehäuse (2) beinhaltet, das eingerichtet ist, um fest mit der aufblasbaren Sicherheitsweste verbunden zu sein, und mit einer ersten Ausnehmung (21) ausgestattet, die imstande ist, reversibel einen Kasten (3) aufzunehmen, der mindestens eine Elektronikkarte, Anschlussmittel und einen Energiespeicher umfasst, wobei die erste Ausnehmung (21) im oberen Teil mit einer Aufnahme (22) ausgestattet ist, auf deren Boden die Anschlussmittel des Gehäuses (2) angeordnet sind, und in die mindestens der obere Teil (31) des Kastens (3) eingeführt wird, um dessen Anschluss in dichter Weise an das Gehäuse (2) zu erlauben.

2. Aktivierungssystem (1) nach Anspruch 1, **dadurch gekennzeichnet, dass** die Anschlussmittel des Gehäuses (2) Dichtungselementen zugewiesen sind, die aus einer Form aus Kunststoff und aus Schaumstoff realisiert werden.

3. Aktivierungssystem (1) nach einem der Ansprüche 1 oder 2, **dadurch gekennzeichnet, dass** die erste Ausnehmung (21) Halteschienen (23) beinhaltet, die beiderseits der ersten Ausnehmung (21) angeordnet sind und das Halten des Kastens (3) am Boden der ersten Ausnehmung (21) und dessen Gleiten erlauben, um dessen Einführung in die Aufnahme (22) zu gestatten, und ein flexibles Befestigungselement (24), das sich im unteren Teil der ersten Ausnehmung (21) befindet und für die Verriegelung des Kastens (3) in der eingeführten Position sorgt.

4. Aktivierungssystem (1) nach Anspruch 3, **dadurch gekennzeichnet, dass** der Kasten (3) Anschlagelemente (32) beinhaltet, die gestaltet sind, um mit den Halteschienen (23) des Gehäuses (2) zusammenzuwirken und darin eingeführt zu werden.

5. Aktivierungssystem (1) nach einem der Ansprüche 1 bis 4, **dadurch gekennzeichnet, dass** der Kasten (3) eine Form aufweist, die eine Asymmetrie im Bereich seines oberen Teils (31) präsentiert, um ihn nur in eine Richtung positionieren und einführen zu können.

6. Aktivierungssystem (1) nach Anspruch 5, **dadurch gekennzeichnet, dass** die asymmetrische Form des oberen Teils (31) des Kastens (3) mindestens teilweise in einem Motiv (26) übernommen ist, das auf dem Gehäuse (2) realisiert ist.

7. Aktivierungssystem (1) nach einem der Ansprüche 2 bis 6, **dadurch gekennzeichnet, dass** sich die Anschlussmittel des Kastens (3) in dessen oberen Teil (31) befinden, und eine ergänzende Form zu jener der Dichtungselement des Gehäuses (2) präsentieren.

8. Aktivierungssystem (1) nach einem der Ansprüche 1 bis 7, **dadurch gekennzeichnet, dass** das Gehäuse (2) fest mit einem Rückenschutz (4) aus einem absorbierenden Material verbunden ist, der eingerichtet ist, um auf der aufblasbaren Sicherheitsweste auf Höhe der Lendenwirbel eines Schifahrers befestigt zu werden, wenn die Weste von diesem Letzteren getragen wird.

9. Aktivierungssystem (1) nach einem der Ansprüche 1 bis 8, **dadurch gekennzeichnet, dass** das Gehäuse (2) eine zweite Ausnehmung (25) beinhaltet, die imstande ist, reversibel Aufblasmittel aufzunehmen, die imstande sind, Gas zu erzeugen oder freizugeben, um das Auslösen der Sicherheitsweste zu erlauben.

10. Aktivierungssystem (1) nach Anspruch 9, **dadurch gekennzeichnet, dass** die Aufblasmittel eine Druckgaskartusche sind.

## Claims

1. System (1) for activating the deployment of an inflatable safety vest, **characterised in that** it comprises a case (2) arranged to be rigidly connected to the inflatable safety vest and equipped with a first opening (21) suitable for receiving, reversibly, a box (3) comprising at least an electronic card, connection means and an energy-storage device, said first opening (21) being provided in the upper part with a housing (22) at the rear whereof are arranged means for connecting the case (2) and wherein at least the upper part (31) of the box (3) is inserted to enable the tight connection thereof with said case (2).

2. Activation system (1) according to claim 1 **characterised in that** said means for connecting the case (2) are associated with sealing elements made from plastic and foam shapes.

3. Activation system (1) according to any one of claims 1 or 2, **characterised in that** the first opening (21) includes holding rails (23) arranged on either side of the first opening (21) and enabling holding of the box (3) at the rear of said first opening (21) and the sliding thereof so as to allow the insertion thereof in the housing (22), and a flexible fastening element (24) situated in the lower part of the first opening (21) and locking said box (3) in the inserted position.

4. Activation system (1) according to claim 3, **characterised in that** the box (3) includes mounting elements (32) designed to engage and be inserted in the rails (23) for holding the case (2).

5. Activation system (1) according to any one of claims 1 to 4 **characterised in that** the box (3) has a shape exhibiting asymmetry at the upper part (31) thereof so as to only be able to position and insert same in one direction.

6. Activation system (1) according to claim 5, **characterised in that** the asymmetric shape of the upper part (31) of the box (3) is repeated at least in part on a pattern (26) created on the case (2).

7. Activation system (1) according to any one of claims 2 to 6, **characterised in that** means for connecting the box (3) are situated on the upper part (31) thereof and exhibit a complementary shape to that of the sealing elements of the case (2).

8. Activation system (1) according to any one of claims 1 to 7, **characterised in that** the case (2) is rigidly connected to a back protection (4) made of absorbent material arranged to be attached to said inflatable safety vest adjacent to the lumbar vertebrae of a skier when said vest is worn by the latter.

9. Activation system (1) according to any one of claims 1 to 8, **characterised in that** said case (2) includes a second opening (25) suitable for receiving, reversibly, inflation means suitable for generating or releasing gas to enable the deployment of the safety vest.

10. Activation system (1) according to claim 9, **characterised in that** the inflation means are a compressed gas cartridge.
